# EUROPÄISCHE PATENTSCHRIFT

(11) **EP 4 627 331 B1**
(45) Veröffentlichungstag und Bekanntmachung des Hinweises auf die Patenterteilung: **23.09.2026**
(21) Anmeldenummer: 23813627.9
(22) Anmeldetag: 24.11.2023
(51) Int. Cl.: G01N 24/08, G01R 31/387, G01R 31/64

(54) **NMR MESSUNGEN AN ELEKTRISCHEN BAUTEILEN WIE INSBESONDERE BATTERIEN UND KONDENSATOREN**
NUCLEAR MAGNETIC RESONANCE MEASUREMENTS ON ELECTRICAL COMPONENTS SUCH AS IN PARTICULAR BATTERIES AND CAPACITORS
MESURES PAR RÉSONANCE MAGNÉTIQUE NUCLÉAIRE SUR DES COMPOSANTS ÉLECTRIQUES TELS QUE DES BATTERIES ET DES CONDENSATEURS PARTICULIERS

(30) Priorität: 28.11.2022 DE 102022131403
(43) Veröffentlichungstag der Anmeldung: 08.10.2025
(73) Patentinhaber: Forschungszentrum Jülich GmbH, 52425 Jülich (DE)
(72) Erfinder: SCHLEKER, Peter Philipp Maria, 52249 Eschweiler (DE); GRANWEHR, Josef Karl, 52428 Jülich (DE); JAKES, Peter, 52428 Jülich (DE); HELLENBRANDT, Christian, 52441 Linnich (DE); EICHEL, Rüdiger-A., 52428 Jülich (DE)
(74) Vertreter: Schwenderling, Jens
(86) Internationale Anmeldenummer: PCT/EP2023/082950
(87) Internationale Veröffentlichungsnummer: WO 2024/115294

(56) Entgegenhaltungen:
- JIAN ZHI HU ET AL: "In situ and ex situ MMR for battery research", JOURNAL OF PHYSICS: CONDENSED MATTER, INSTITUTE OF PHYSICS PUBLISHING, BRISTOL, GB, vol. 30, no. 46, 30 October 2018 (2018-10-30), pages 463001, XP020332026, ISSN: 0953-8984, [retrieved on 20181030], DOI: 10.1088/1361-648X/AAE5B8
- STEFFEN A KAYSER ET AL: "Long-run in-operando NMR to investigate the evolution and degradation of battery cells", ARXIV.ORG, CORNELL UNIVERSITY LIBRARY, 201 OLIN LIBRARY CORNELL UNIVERSITY ITHACA, NY 14853, 6 October 2017 (2017-10-06), XP081147353, DOI: 10.1039/C8CP01067F
- KRACHKOVSKIY SERGEY A. ET AL: "Real-Time Quantitative Detection of Lithium Plating by In Situ NMR Using a Parallel-Plate Resonator", JOURNAL OF THE ELECTROCHEMICAL SOCIETY, 21 September 2020 (2020-09-21), Internet, XP093139295, Retrieved from the Internet <URL:https://iopscience.iop.org/article/10.1149/1945-7111/abb7ea/pdf> [retrieved on 20240308], DOI: 10.1149/1945-7111
- BENDERS STEFAN ET AL: "Nuclear magnetic resonance spectroscopy of rechargeable pouch cell batteries: beating the skin depth by excitation and detection via the casing", SCIENTIFIC REPORTS, vol. 10, no. 1, 13 August 2020 (2020-08-13), US, XP093127695, ISSN: 2045-2322, Retrieved from the Internet <URL:https://www.nature.com/articles/s41598-020-70505-0> [retrieved on 20240206], DOI: 10.1038/s41598-020-70505-0
- AGUILERA ANDRÉS RAMÍREZ ET AL: "A parallel-plate RF probe and battery cartridge for 7Li ion battery studies", JOURNAL OF MAGNETIC RESONANCE., vol. 325, 18 February 2021 (2021-02-18), US, pages 106943, XP093127666, ISSN: 1090-7807, DOI: 10.1016/j.jmr.2021.106943
- WALDER BRENNAN J. ET AL: "NMR spectroscopy of coin cell batteries with metal casings", SCIENCE ADVANCES, vol. 7, no. 37, 10 September 2021 (2021-09-10), US, pages 1 - 13, XP093116757, ISSN: 2375-2548, DOI: 10.1126/sciadv.abg8298

## Beschreibung

Gegenstand der vorliegenden Erfindung ist ein Verfahren zum Durchführen von NMR (nuclear magnetic resonance, Kernspinresonanz) Messungen an elektrischen Bauteilen wie insbesondere Batterien und Kondensatoren.

Batterien aber auch Kondensatoren weisen elektrische Anschlüsse auf, die im Inneren der Batterie oder des Kondensators nicht durch einen durchgehenden elektrischen Leiter elektrisch miteinander verbunden sind. Vielmehr ist im Falle eines Kondensators beispielsweise ein Dielektrikum zwischen zwei Elektroden ausgebildet, wobei die Elektroden über Pole mit anderen Elementen elektrisch verbindbar sind. Alternativ kann auch ein Elektrolyt zwischen den Elektroden des Kondensators ausgebildet sein, wobei in diesem Falle zumindest an einer Elektrode ein Dielektrikum ausgebildet ist. Im Falle einer Batterie sind die Pole der Batterie ebenfalls mit Elektroden verbunden, die im Inneren der Batterie nicht über einen durchgehenden elektrischen Leiter miteinander verbunden, sondern zwischen denen ein Elektrolyt ausgebildet ist, der die Bewegung von Ionen hin zu den Elektroden der Batterie erlaubt und gleichzeitig die Bewegung von Elektronen zwischen den Elektroden unterbindet.

Batterien und Kondensatoren haben gemeinsam, dass diese metallische Bauteile aufweisen. Metallische Bauteile führen üblicherweise zu Problemen bei der Durchführung von NMR-Messungen, da die metallischen Bauteile zu Artefakten im akquirierten Messsignal führen. Gleichzeitig führt der Skin-Effekt dazu, dass eine normale NMR-Messung an Proben mit außen geschlossener metallischer Hülle nur sehr eingeschränkt möglich ist, da die Hochfrequenz- Pulse, die zur Durchführung der NMR-Messung notwendig sind, nur zu Effekten auf der Oberfläche des metallischen Bauteils führen und effektiv ein Eindringen des Hochfrequenz-Pulses in die Tiefe der Probe nicht möglich ist.

Hu, Jian Zhi et al.: "In situ and ex situ NMR for battery research", Journal of Physics: Condensed Matter, Institute of Physics Publishing, Bristol, GB, Bd. 30, Nr. 46, 30. Oktober 2018, S. 463001, DOI: 10.1088/1361-648X/AAE5B8 beschreibt NMR-Messmethoden zur Untersuchung elektrochemischer Prozesse in Batterien.

Kayser, Steffen A. et al.:"Long-run in-operando NMR to investigate the evolution and degradation of battery cells", ARXIV.ORG, Cornell University Library, Ithaca, NY, 6. Oktober 2017, DOI: 10.1039/C8CP01067F beschreibt in-operando NMR-Verfahren zur Untersuchung einer Zweielektroden-Batterie.

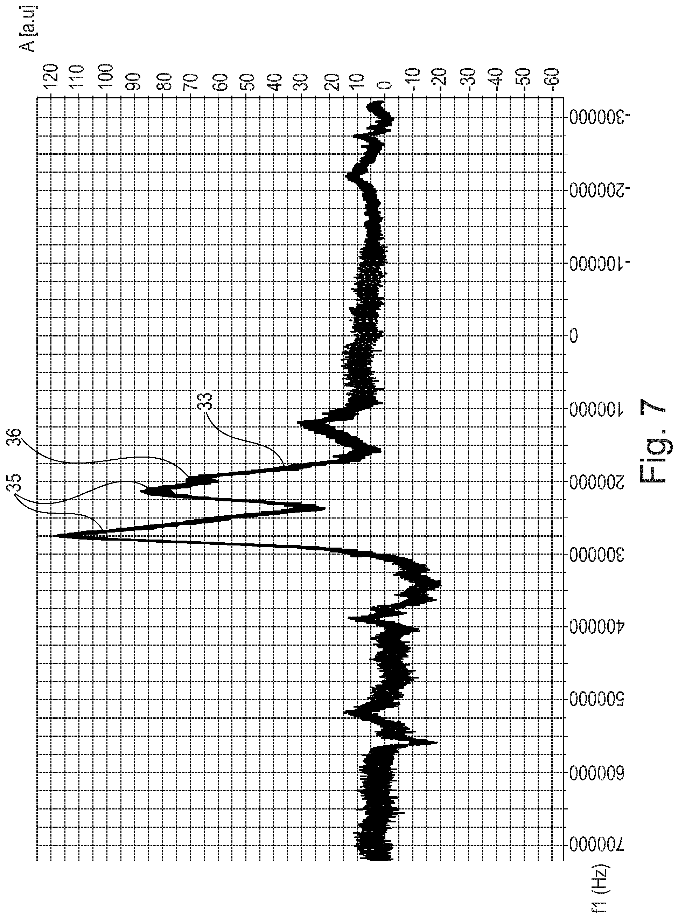

Krachkovskiy, S. A. et al.: "Real-Time Quantitative Detection of Lithium Plating by in Situ NMR Using a Parallel-Plate Resonator", Journal of the Electrochemical Society, 21. September 2020, DOI: 10.1149/1945-7111/abb7ea beschreibt ein NMR-Verfahren zur Untersuchung eines elektrischen Bauteils mit zwei Elektroden.

Ausgehend vom eingangs erläuterten Stand der Technik liegt der Erfindung die Aufgabe zugrunde, eine NMR-Messung an elektrischen Bauteilen wie insbesondere Batterien und Kondensatoren zu ermöglichen. Diese Aufgabe wird gelöst mit den Merkmalen des unabhängigen Anspruchs. Die abhängigen Ansprüche sind auf vorteilhafte Weiterbildungen gerichtet.

Vorsorglich sei angemerkt, dass die hier verwendeten Zahlwörter ("erste", "zweite", ...) vorrangig (nur) zur Unterscheidung von mehreren gleichartigen Gegenständen, Größen oder Prozessen dienen, also insbesondere keine Abhängigkeit und/oder Reihenfolge dieser Gegenstände, Größen oder Prozesse zueinander zwingend vorgeben. Sollte eine Abhängigkeit und/oder Reihenfolge erforderlich sein, ist dies hier explizit angegeben oder es ergibt sich offensichtlich für den Fachmann beim Studium der konkret beschriebenen Ausgestaltung.

Das erfindungsgemäße Verfahren zum Untersuchen eines elektrischen Bauteils mit einem ersten Pol und einem zweiten Pol, wobei das Bauteil über die Pole elektrisch verbindbar ist, wobei das Bauteil zwei Elektroden aufweist, wobei jeweils eine Elektrode mit genau einem Pol elektrisch verbunden ist und das Bauteil keine metallische Verbindung zwischen den Elektroden aufweist, wobei in dem Bauteil zwischen den Elektroden eine Substanz ausgebildet ist, wobei das Bauteil einem zeitlich konstanten Magnetfeld und einem impulsförmig geschalteten Hochfrequenzfeld ausgesetzt wird und die Daten in Form mindestens eines Spinresonanzsignals gemessen werden, zeichnet sich dadurch aus, dass das Bauteil über seine Pole elektrisch in einen Schwingkreis eingebunden wird, über den das Hochfrequenzfeld innerhalb des Bauteils angeregt und das Spinresonanzsignal aufgenommen wird.

Unter den Polen werden die Anschlüsse verstanden, über die das elektrische Bauteil üblicherweise elektrisch mit anderen Elementen verbunden wird. Beispielsweise weist eine Primärbatterie oder eine Sekundärbatterie einen "+"-Pol und einen "-"-Pol auf. Bei einem Kondensator werden die elektrischen Anschlüsse des Kondensators im Sinne dieses Dokuments als Pole verstanden. Es liegt im Inneren des Bauteils keine metallische Verbindung zwischen den Elektroden vor. Dies ist beispielsweise bei Batterien oder Kondensatoren der Fall. Batterien und Kondensatoren wären bei Vorliegen einer metallischen Verbindung zwischen den Polen kurzgeschlossen. Batterien umfassen insbesondere Primär- und Sekundärbatterien der Bauformen AA, AAA, 21700, 18650, 26650, 4680, Knopfzellen sowie Pouchzellen und Swagelok-Zellen.

Das zeitlich konstante Magnetfeld wird als BO-Feld bezeichnet. Es wird bevorzugt von einem Elektromagneten oder einem supraleitenden Magneten erzeugt. Alternativ kann auch ein Permamentmagnet zur Erzeugung des B0-Feldes eingesetzt werden. Bevorzugt können kleinere zusätzliche Magnetfelder zur Homogenisierung des zeitlich und räumlich konstanten Magnetfeldes überlagert werden. Alternativ kann durch Überlagerung eines oder mehrerer weiterer Magnetfelder ein gezielt räumlich inhomogenes, aber zeitlich konstantes, Magnetfeld erzeugt werden, so dass nur bestimmte räumliche Bereiche resonant durch das impulsförmig geschaltete Hochfrequenzfeld angeregt werden oder sogar ein bildgebendes Verfahren durch eine gezielte räumliche Veränderung des zeitlich konstanten Magnetfeldes erreicht werden kann.

Die magnetische Flussdichte des B0-Feldes bestimmt die Resonanzfrequenz innerhalb des Magnetfeldes für einen mit der NMR-Messung zu untersuchenden Atomkern, beispielsweise 1-Wasserstoff (¹H) oder 7-Lithium (⁷Li), die auch als Larmor-Frequenz bezeichnet wird. Der Schwingkreis weist bevorzugt mindestens zwei abstimmbare Kondensatoren auf, über die einerseits der Schwingkreis auf die Resonanzfrequenz abgestimmt werden kann (auch als "tuning" bezeichnet) und andererseits eine Signalmaximierung des Spinresonanzsignals und eine Reduktion von Reflexionen des Hochfrequenzsignals erreicht werden kann (auch als "matching" bezeichnet), wodurch eine Anpassung der Impedanz des Schwingkreises erfolgt. Die beiden Kondensatoren können entsprechend als Tune und Match bezeichnet werden. Durch Abstimmung der Kondensatoren kann die Eigenfrequenz des Schwingkreises auf das jeweils zu untersuchende Isotop angepasst werden. Insbesondere beim Einsatz eines Elektromagneten könnte alternativ oder zusätzlich auch das Magnetfeld angepasst werden. Das Hochfrequenzfeld ist ein magnetisches Hochfrequenzfeld, dessen Frequenz auf übliche Art und Weise in Abhängigkeit unter anderem vom BO-Feld und vom zu untersuchenden Atomkern bestimmt wird.

Die Substanz ist bevorzugt ein Gas, eine Flüssigkeit oder ein Festkörper. Bevorzugt ist die Substanz ein Elektrolyt und/oder ein Dielektrikum.

Die Einbindung des Bauteils in den Schwingkreis bezeichnet die Herstellung einer elektrischen Verbindung zwischen den Polen des Bauteils und den anderen Elementen des Schwingkreises durch elektrische Kontaktierung. Die Einbindung des Bauteils umfasst insbesondere keine kapazitive Kopplung oder ähnliches.

Durch das Einbinden des Bauteils in den Schwingkreis werden die Elektroden des Bauteils und/oder die Stromabnehmer in den Schwingkreis eingebunden und emittieren das Hochfrequenzfeld in die Substanz und damit in das Innere des Bauteils und nehmen das Spinresonanzsignal, welches das Bauteil charakterisiert, wieder auf. Die Signalerzeugung des Hochfrequenzfeldes und die Aufzeichnung des Spinresonanzsignals erfolgt über die übliche Elektronik eines NMR-Spektrometers, die beispielsweise entsprechende Frequenzsynthesizer und Verstärker umfasst. Die Elektroden wirken dabei quasi als Induktivität, insbesondere als Spule, im Schwingkreis. Statt also das Bauteil in die übliche Spule eines NMR-Probenkopfes einzuführen, werden die Elektroden des Bauteils als Spule bei der NMR Messung eingesetzt. Überraschenderweise lassen sich dadurch reproduzierbar NMR Messungen an Bauteilen wie Batterien oder Kondensatoren durchführen. Die erhaltenen NMR-Spektren sind reproduzierbar und sind vom Aufbau und Zustand des Bauteils abhängig.

Insbesondere ist es durch das hier beschriebene Verfahren möglich, kommerziell erhältliche Batterien und Kondensatoren mit NMR zu vermessen, auch wenn diese ein metallisches Gehäuse aufweisen. Die erhaltenen NMR Spektren von Batterien sind Batterie-individuell, die Batterien unterschiedlicher Hersteller weisen also unterschiedliche Spektren auf, und Zustands-individuell. Die erhaltenen Spektren sind also auch reproduzierbar individuell für unterschiedliche Ladezustände und Anzahlen von Ladezyklen. Ähnliches gilt auch für die Messung von Kondensatoren. Somit lässt sich das hier geschilderte Verfahren zur Charakterisierung von elektrischen Bauteilen wie Batterien oder Kondensatoren einsetzen.

Bevorzugt umfasst der Schwingkreis mindestens zwei abstimmbare Kondensatoren, über die die Frequenz und die Impedanz des Schwingkreises anpassbar sind. Somit ist es möglich, das erhaltene Spinresonanzsignal an das lokale BO-Feld am Ort des Bauteils anzupassen. Die beiden abstimmbaren Kondensatoren ermöglichen ein "tuning" und "matching" wie oben beschrieben. Alternativ ist es auch möglich, eine oder mehrere abstimmbare Spulen vorzusehen. Durch die Abstimmbarkeit durch Kondensatoren und/oder Spulen oder andere Elemente kann der Schwingkreis an unterschiedliche Resonanzfrequenzen bei gegebenem zeitlich konstantem Magnetfeld und damit an unterschiedliche Kerne angepasst werden.

Bevorzugt umfasst das Bauteil eine Batterie oder einen Wickel für eine Batterie. Eine Batterie umfasst bevorzugt zwei leitfähige Elektroden. Bevorzugt sind die Elektroden aus einem keramischen Material ausgebildet, welches mit einem leitfähigen Material versehen sind. Bei dem leitfähigen Material handelt es sich bevorzugt um ein Material umfassend Kohlenstoff, insbesondere Leitruß und/oder Carbon. Auf die Elektroden ist ein Elektrodenmaterial aufgebracht, welches der Ioneneinlagerung dient und mit einem Elektrolyten verbunden sind. Die Elektroden sind durch einen Separator getrennt, der eine elektrische Isolierung zur Verhinderung eines elektrischen Kurzschlusses und eine mechanische Trennung zwischen den Elektroden darstellt. Bevorzugt umfasst die Substanz einen Elektrolyten. Als Elektrolyt wird ein Medium bezeichnet, welches durch darin enthaltene Ionen elektrisch leitfähig ist. Der Elektrolyt ist bevorzugt flüssig, ein Festkörper, eine Schmelze, ein Gel oder ein Polymermaterial oder umfasst eine Mischung aus mindestens zwei der vorgenannten Materialien. In einer Batterie wird der Elektrolyt dazu genutzt, den Ladungsausgleich zwischen den Elektroden (Kathode und Anode) herbeizuführen.

Insbesondere kann das beschriebene Verfahren eingesetzt werden, um eine Batterie vom Typ 18650 zu untersuchen. Die Bezeichnung "Typ 18650" ist allgemeingebräuchlich für eine zylinderförmige Batterie mit einem Durchmesser von 18 mm und einer Länge von 65 mm. Es hat sich herausgestellt, dass das Konzept des hierin beschriebenen Verfahrens insbesondere auf diesen industriell bedeutenden Batterie-Typ angewendet werden kann. Dazu wird die Batterie vom Typ 18650 wie beschrieben als Resonator in einen Schwingkreis eingebunden und mittels NMR untersucht.

Das beschriebene Verfahren kann insbesondere dazu eingesetzt werden, bestimmte Isotope oder Elemente innerhalb einer geschlossenen Batterie mittels NMR zu detektieren und zu charakterisieren. Durch das beschriebene Verfahren ist es möglich, Batterien verschiedener Hersteller miteinander zu vergleichen. Das ist insbesondere sinnvoll, um Batterien mit festgelegten Spezifikationen miteinander zu vergleichen. Das ist beispielsweise bei Batterien vom Typ18650 der Fall. Durch das beschriebene Verfahren ist es insbesondere auch möglich, die Chemie einer Batteriezelle zu bestimmen.

Das zu untersuchende Bauteil muss keine vollständige Batterie umfassen. Daher ist bevorzugt, dass das Bauteil anstelle einer Batterie als solcher nur einen Wickel für eine Batterie umfasst. Dies gilt insbesondere für Batterien vom Typ 18650, darüber hinaus aber auch für Batterien allgemein. Wird eine Batterie als elektrisches Bauteil eingesetzt, so kann die NMR-Messung nach dem hier beschriebenen Verfahren dazu eingesetzt werden, Daten über die Batterie und/oder über die Substanz zu sammeln. Insbesondere bei Sekundärbatterien, also wiederaufladbaren Batterien, kommt es durch die Lade- und Entladezyklen zu strukturellen und chemischen Veränderungen innerhalb der Batterie, die sich in den gemessenen NMR Spektren durch Veränderungen bemerkbar machen. Entsprechendes gilt auch für Primärbatterien. So erlaubt das hier vorgestellte Verfahren eine Charakterisierung einer Batterie in Abhängigkeit vom Ladezustand, vom strukturellen Zustand, Alter, etc. Durch die Durchführung der NMR-Messung wie hier beschrieben an einer Batterie ist es möglich, ein Spinresonanzsignal zu generieren, welches nicht nur aus der Substanz zwischen den Elektroden herrührt, sondern auch von den Elektroden selbst beeinflusst wird. Dadurch ist es möglich, durch das hier beschriebene Verfahren Veränderungen der Elektrode oder des Elektrodenmaterials zu messen, insbesondere strukturelle und chemische Veränderungen wie beispielsweise eine Korrosion einer oder beider Elektroden.

Bevorzugt umfasst das Bauteil einen Kondensator. Bevorzugt umfasst die Substanz ein Dielektrikum. Unter einem Dielektrikum wird eine elektrisch schwach oder nichtleitende Substanz verstanden, in der die vorhandenen Ladungsträger frei beweglich oder polarisierbar sind. Das Dielektrikum ist bevorzugt eine Flüssigkeit oder ein Feststoff. Alternativ sind auch gasförmige Dielektrika wie beispielsweise Luft möglich. Bevorzugt weist das Dielektrikum eine relative Permittivität von mindestens 1 auf. Weiterhin umfasst die Substanz des Kondensators bevorzugt einen Elektrolyten, der zwischen den Elektroden ausgebildet ist.

Wird ein Kondensator als elektrisches Bauteil eingesetzt, so kann die NMR Messung nach dem hier beschriebenen Verfahren dazu eingesetzt werden, Daten über den Kondensator und insbesondere über das Dielektrikum des Kondensators und/oder die Elektroden des Kondensators zu sammeln. Insbesondere können mit dem hier beschriebenen Verfahren Daten gesammelt werden, die eine Aussage zum strukturellen und chemischen Zustand des Kondensators erlauben. Insbesondere bei hochpreisigen Kondensatoren oder auch so genannten Superkondensatoren ist es vorteilhaft, diese charakterisieren zu können, um beispielsweise fehlerhafte Kondensatoren aussondern zu können oder um Alterungsprozesse im Kondensator nachvollziehen zu können. Mit dem hier beschriebenen Verfahren ist die Durchführung von NMR Messungen an Keramikkondensatoren, Elektrolytkondensatoren, Doppelschichtkondensatoren, Folienkondensatoren und Plattenkondensatoren bevorzugt möglich. Besonders bevorzugt ist die Messung an so genannten Superkondensatoren, die als elektrochemische Kondensatoren ausgebildet sind.

Bevorzugt wird anhand der magnetischen Flussdichte des zeitlich konstanten Magnetfeldes die Resonanzfrequenz und/oder die Intensität eines der folgenden Atomkerne bestimmt: 1-Wasserstoff (¹H); 6-Lithium (⁶Li); 7-Lithium (⁷Li); 13-Kohlenstoff (¹³C); 14-Stickstoff (14N); 19-Fluor (¹⁹F); 23-Natrium (²³Na); 27-Aluminium (²⁷Al); 29-Silicium (²⁹Si); 31-Phosphor (³¹P); 39-Kalium (³⁹K) ; 59-Cobalt (⁵⁹Co), 111-Cadmium (¹¹¹Cd) , 113-Cadmium (¹¹³Cd) oder 207-Blei (²⁰⁷Pb) und diese Resonanzfrequenz als Frequenz des Hochfrequenzfeldes eingesetzt wird. Auch Fe, Mn, Zn, Ti, V, Cd, Cu können verwendet werden. Die Resonanzfrequenz berücksichtigt neben der eigentlichen Larmorfrequenz insbesondere auch die entsprechende chemische Verschiebung. Das hier beschriebene Verfahren erlaubt die Durchführung von NMR Messungen an elektrischen Bauteilen wie Kondensatoren oder Batterien, bei denen durch die Wahl eines der oben genannten Atomkerne in Abhängigkeit vom Aufbau und der Zusammensetzung der Substanz ein Spinresonanzsignal erzeugt werden kann, welches der Charakterisierung des Zustandes der Batterie oder des Kondensators dient. Durch Messung der genannten Isotope können Aussagen zum Zustand des untersuchten Bauteils getroffen werden. Das gilt insbesondere im Falle einer Batterie als dem untersuchten Bauteil. Insbesondere ist es möglich, eine Natriumionenbatterie durch die Detektion von 23-Natrium (²³Na) zu untersuchen und die verschiedenen Zustände des Elements Natrium, insbesondere metallisch und solvatisiertes Na⁺, zu detektieren. Entsprechendes gilt für 6-Lithium (⁶Li) und 7-Lithium (⁷Li).

Alternativ ist es bevorzugt, eine Isotopenanreicherung an dem Bauteil vorzunehmen und dann die Resonanzfrequenz mindestens eines der folgenden Atomkerne zu verwenden: 2-Wasserstoff (²H), 15-Stickstoff (¹⁵N); 17-Sauerstoff (¹⁷O) oder 33-Schwefel (³³S). Bevorzugt wird die Resonanzfrequenz eines der folgenden Atomkerne bestimmt und diese Resonanzfrequenz als Frequenz des Hochfrequenzfeldes verwendet: 25-Magnesium (²⁵Mg), 35-Chlor und 37-Chlor (²⁵Cl und ³⁷Cl), 47-Titan und 49-Titan (⁴⁷Ti und ⁴⁹Ti), 51-Vanadium (⁵¹V), 57-Eisen (⁵⁷Fe), 55-Mangan (⁵⁵Mn), 59-Cobalt (⁵⁹Co), 61-Nickel (⁶¹Ni), 63-Kupfer und 65-Kuper (⁶³Cu und ⁶⁵Cu), 73-Germanium (⁷³Ge), 89-Yttrium (⁸⁹Y), 91-Zirkon (⁹¹Zr), 107-Silber und 109-Silber (¹⁰⁷Ag und ¹⁰⁹Ag), 127-Iod (¹²⁷I) und 139-Lanthan (¹³⁹La).

Bevorzugt weist das Bauteil einen zylinderförmigen Aufbau mit einer Zylinderachse auf und die Zylinderachse in Richtung des magnetischen Flusses des zeitlich und räumlich homogenen Magnetfeldes ausgerichtet ist. Hierdurch wird für zylinderförmige Bauteile eine Signalmaximierung des Spinresonanzsignals erreicht. Dies ist insbesondere für längliche Zylinder bevorzugt, wie beispielsweise AA- oder AAA-Batterien, bei denen eine Stirnfläche des Zylinders kleiner ist als die Mantelfläche des Zylinders.

Bevorzugt weist das Bauteil einen flächigen Aufbau mit zwei einander gegenüberliegenden größten Fläche auf und das Bauteil ist so ausgerichtet, dass die größte Fläche in Richtung des magnetischen Flusses des zeitlich und räumlich homogenen Magnetfeldes ausgerichtet ist. Unter einem flächigen Aufbau werden in diesem Zusammenhang bevorzugt quaderförmige oder flache zylindrische Bauteile verstanden. Quaderförmige Bauteile wie beispielsweise Batterien werden regelmäßig eingesetzt, so zum Beispiel in Mobiltelefonen und ähnlichem. Der Aufbau als Quader bewirkt, dass mindestens zwei Flächen des Quaders größte Flächen sind, insbesondere, wenn mindestens zwei der Flächen rechteckige und nicht quadratische Flächen sind. Größte Flächen bedeutet insbesondere, dass der Flächeninhalt dieser Flächen größer ist als der Flächeninhalt der anderen Flächen. Aufgrund des Aufbaus als Quader liegen zwei größte Flächen einander gegenüber. Eine flache zylindrische Geometrie zeichnet sich dadurch aus, dass die Stirnfläche des Zylinders größer ist als die Mantelfläche des Zylinders. Ein Beispiel für flache zylindrische Bauteile stellen Knopfzellen dar. Aufgrund des Aufbaus insbesondere einer Batterie kann die Ausrichtung einer größten Fläche in Richtung des magnetischen Flusses des zeitlich und räumlich homogenen Magnetfeldes eine Signalmaximierung des Spinresonanzsignals bewirken.

Bevorzugt ist das zeitlich konstante Magnetfeld räumlich konstant, im Rahmen einer vorgegebenen Messgenauigkeit oder Linienbreite. Dies ermöglicht spektroskopische Messungen des gesamten Bauteils.

Bevorzugt weist das zeitlich konstante Magnetfeld mindestens in einer Raumrichtung einen Gradienten auf. Dies ermöglicht einerseits eine Gestaltung des zeitlich konstanten Magnetfeldes genau so, dass nur ein vorgebbarer Teilbereich des Bauteils resonant ist und damit zum Spinresonanzsignal beiträgt. Andererseits ist es so möglich, eine ein-, zwei- oder sogar dreidimensionale Ortsauflösung zu erzeugen und so bildgebende Verfahren (MRI, magnetic resonance imaging) anzuwenden.

Bevorzugt wird das hier beschriebene Verfahren zu Durchfühung von Hochfeld-NMR-Experimenten (insbesondere mit einem zeitlich konstanten Magnetfeld von mindestens 10 mT [Millitesla]) an kommerziellen Batterien verwendet, welche sich bevorzugt in einem Metallgehäuse befinden. Besonders bevorzugt ist der Einsatz des hier beschriebenen Verfahrens zur nichtdestruktiven Qualitätskontrolle von Batterien und Kondensatoren, z.B. durch Vergleich mit einem einen Standard definierenden Referenzspektrum. Bevorzugt wird das hier beschriebene Verfahren eingesetzt, um den Ladungszustand einer Batterie zu bestimmen, z.B. durch Vergleich mit Referenzspektren. Bevorzugt wird das hier beschriebene Verfahren eingesetzt, um Degradations- und Alterungsprozesse von Batterien und Kondensatoren zu bestimmen, beispielsweise durch Änderung von Resonanzen (Frequenz, Phase, Amplitude, Breite bzw. Linienform), Verschwinden von bestimmten Resonanzen oder zusätzlich erscheinende Resonanzen. Bevorzugt wird das hier beschriebene Verfahren eingesetzt, um eine Degradation des Elektrolyten und der Elektrodenmaterialien einer Batterie zu charakterisieren und eine entsprechende Qualitätskontrolle darzustellen. Das erfindungsgemäße Verfahren wird bevorzugt auch eingesetzt, um die Magnetisierung eines Bauteils zu überwachen. Die Änderung der Magnetisierung eines Bauteils beispielsweise einer Batterie zeigt sich in einem zu anderen Frequenzen verschobenen Spektrum.Die Erfindung sowie das technische Umfeld werden nachfolgend anhand der Figuren näher erläutert. Es ist darauf hinzuweisen, dass die Erfindung durch die gezeigten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung und/oder Figuren zu kombinieren. Insbesondere ist darauf hinzuweisen, dass die Figuren und insbesondere die dargestellten Größenverhältnisse nur schematisch sind. Gleiche Bezugszeichen bezeichnen gleiche Gegenstände, so dass ggf. Erläuterungen aus anderen Figuren ergänzend herangezogen werden können. Es zeigen:
- Fig. 1: einen Aufbau eines Beispiels einer Vorrichtung zum Untersuchen eines elektrischen Bauteils wie eines Kondensators oder einer Batterie;
- Fig. 2: einen Aufbau eines Beispiels eines Probenkopfes zum Untersuchen eines elektrischen Bauteiles wie eines Kondensators oder einer Batterie;
- Fig. 3: sehr schematisch ein Beispiel eines Aufbaus eines elektrischen Bauteils;
- Fig. 4: sehr schematisch einen Hochfrequenzpuls und ein Spinresonanzsignal;
- Fig. 5: ein ¹H-NMR Spektrum einer AA-Batterie;
- Fig. 6: drei 1H-NMR Spektren einer AA-Batterie;
- Fig. 7bis 9: ⁷Li-Spektren einer AAA-Batterie in unterschiedlichen Ladezuständen;
- Fig. 10 und 11: ⁷Li-Spektren einer Knopfzelle, die senkrecht (Fig. 10) und parallel (Fig. 11) zum BO-Feld ausgerichtet ist;
- Fig. 12 und 13: ⁷Li-Spektren eines flächigen Akkumulators einer Kamera, der senkrecht (Fig. 12) und parallel (Fig. 13) zum BO-Feld ausgerichtet ist;
- Fig. 14 und 15: ⁷Li-Spektrum (Fig. 14) und ⁵⁹Co-Spektrum (Fig. 15) eines Wickels einer Batterie vom Typ 18650;
- Fig. 16 und 17: ⁷Li-Spektren verschiedener Batterien vom Typ 18650;
- Fig. 18 und 19: ¹H-Spektrum (Fig. 18) und ⁷Li -Spektrum (Fig. 19) einer Pouchbag-Zelle;
- Fig. 20: ⁷Li -Spektrum einer Swagelok-Zelle mit Lithium-Metall und Lithium-Nickel-Cobalt-Aluminiumoxid (LNCA);
- Fig. 21: ²³Na -Spektrum einer Swagelok-Zelle mit Natrium-Metall und Hardcarbon.

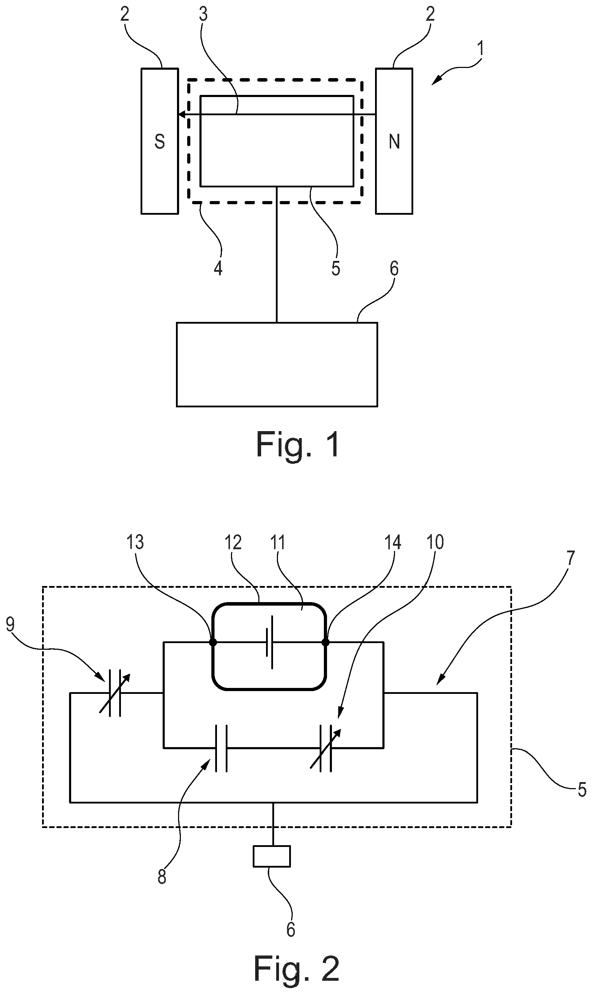

Fig. 1 zeigt einen Aufbau einer Vorrichtung 1 zum Durchführen von NMR Messungen an einem elektronischen Bauteil wie einer Batterie oder einem Kondensator. Diese Vorrichtung 1 umfasst einen Magneten 2, der ein zeitlich und räumlich homogenes Magnetfeld 3 erzeugt. Bei dem Magneten 2 handelt es sich bevorzugt um einen Permanentmagneten, einen Elektromagneten oder einen supraleitenden Elektromagneten. Der Magnet 2 weist einen Probenaufnahmeraum 4 auf, in dem das Magnetfeld 3 hinreichend homogen ist. Es wird also ein zeitlich und räumlich konstantes Magnetfeld eingesetzt. Alternativ kann das Magnetfeld 3 gezielt räumlich inhomogen mit mindestens einem Gradienten gestaltet werden.

In den Probenaufnahmeraum 4 des Magneten 2 wird ein Probenkopf 5 eingebracht. Der Probenkopf 5 wird elektrisch mit einem NMR Spektrometer 6 verbunden. Der Probenkopf 5 und das NMR Spektrometer 6 werden elektrisch miteinander verbunden. Das NMR Spektrometer 6 umfasst unter anderem einen Hochfrequenzsender und einen Hochfrequenzempfänger, über die ein hochfrequenter RF Puls im Probenkopf 5 induziert und ein Zerfall einer Magnetisierung im Probenkopf 5 als Spinresonanzsignal detektiert werden kann.

Fig. 2 zeigt schematisch den Aufbau eines Probenkopfes 5. Dieser umfasst einen Schwingkreis 7, der in diesem Beispiel einen Kondensator 8, einen ersten abstimmbaren Kondensator 9 und einen zweiten abstimmbaren Kondensator 10 und ein zu vermessendes Bauteil 11, das in einer Bauteilaufnahme 12 aufgenommen ist, umfasst. Der Kondensator 8 ist bevorzugt austauschbar gestaltet, um weitere Frequenzbereich im Probenkopf 5 darstellen zu können.

Die Bauteilaufnahme 12 ist so ausgebildet, dass das Bauteil 11, das einen ersten Pol 13 und einen zweiten Pol 14 aufweist, mit seinen Polen 13, 14 mit den übrigen Elementen des Schwingkreises 7 wie gezeigt durch elektrische Kontaktierung verbunden wird. Die Pole 13, 14 werden auch als Stromabnehmer bezeichnet.

Das Bauteil 11 wird also nicht in eine Spule eingebracht, die Teil des Schwingkreises 7 ist. Vielmehr wird die Batterie 11 selbst Teil des Schwingkreises 7 und über die Pole 13, 14 in den Schwingkreis 7 eingebunden. Ein Hochfrequenzpuls wird somit mit den elektrischen Elementen der Batterie 11 erzeugt und ein Zerfall der durch den Hochfrequenzpuls entstehenden Magnetisierung mit den elektrischen Elementen des Bauteils 11 als Spinresonanzsignal detektiert. Überraschenderweise sind dadurch reproduzierbare NMR-Spektren aufnehmbar, anhand derer das elektrische Bauteil 11 charakterisierbar ist. Insbesondere ist das detektierte Spinresonanzsignal abhängig vom Aufbau des elektrischen Bauteils 11 und vom Zustand des elektrischen Bauteils 11. Zum Spinresonanzsignal trägt alles bei, was zwischen den beiden Polen 13, 14 (oder auch Stromabnehmern) ausgebildet ist.

Bei dem erfindungsgemäßen Verfahren wird eine Frequenz des Hochfrequenz-pulses gewählt, die einer NMR Resonanzfrequenz (oder Larmorfrequenz) beispielsweise eines 1-Wasserstoffkerns oder des 7 Lithiumkerns bei der Feldstärke des angelegten zeitlich und räumlich konstanten Magnetfeldes 3 des Magneten 2 entspricht. Hierdurch kann ein Spinresonanzsignal gewonnen werden, welches durch die entsprechenden Protonen oder 7-Lithiumkerne der weiteren Materialien in der Batterie 11 erzeugt wird.

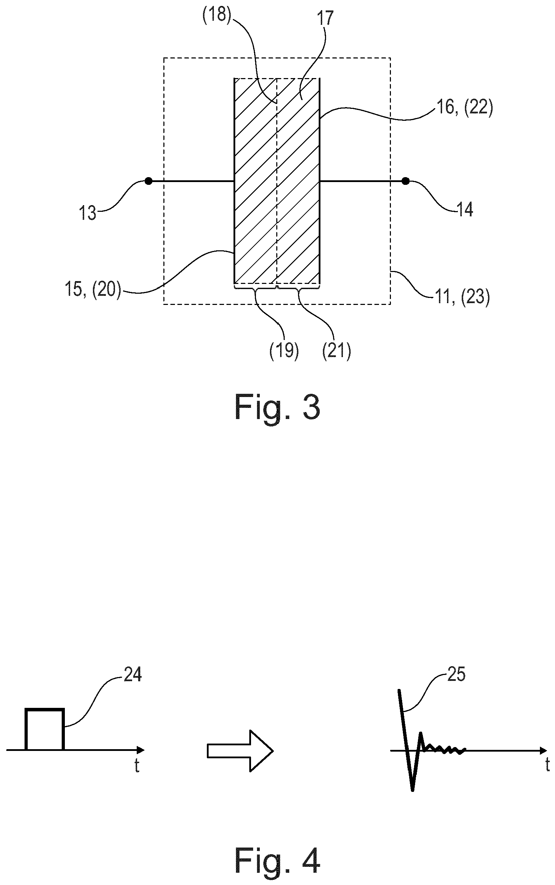

Fig. 3 zeigt sehr schematisch ein Beispiel eines Aufbaus eines Bauteils 11. Hierbei kann es sich sowohl um eine Batterie als auch um einen Kondensator handeln. Der erste Pol 13 ist mit einer ersten Elektrode 15 und der zweite Pol 14 mit einer zweiten Elektrode 16 leitend verbunden. Zwischen den Elektroden 15, 16 besteht keine metallische Verbindung. Zwischen den Elektroden 15, 16 ist eine Substanz 17 ausgebildet, die bevorzugt als Dielektrikum oder Elektrolyt ausgebildet ist. Auf den Elektroden 15, 16 ist bevorzugt ein Elektrodenmaterial ausgebildet, welches der Aufnahme von Ionen dient. Weiterhin bevorzugt ist ein Separator ausgebildet, der einen elektrischen Kurzschluss der Elektroden 15, 16 verhindert, aber eine ionische Leistung zwischen den Elektroden 15, 16 zulässt. Der gezeigte Aufbau ist schematisch, insbesondere kann das Bauteil auch als gewickeltes Bauteil ausgebildet werden, bei dem beispielsweise die Elektroden 15, 16 mit der Substanz 17 umeinander gewickelt sind, beispielsweise in Form einer zylindrischen Zelle.

Handelt es sich bei dem Bauteil 11 um eine Batterie 23, so umfasst die Substanz 17 regelmäßig zusätzlich einen Separator 18, mit dem ein anodischer Teil 19 der Batterie 23 mit einer Anode 20 als Elektrode 15 von einem kathodischen Teil 21 der Batterie 23 mit einer Kathode 22 als Elektrode 16 getrennt wird, der für Ionen wie beispielsweise Lithium-Ionen permeabel ist, die von der Anode 20 durch den als Elektrolyt gebildete Substanz 17 zur Kathode 22 wandern, um einen Ladungsausgleich zu erzeugen. Der Separator 18, die Batterie 23, die Anode 20, der anodische Teil 19, die Kathode 22 und der kathodische Teil 21 sind mit Bezugszeichen in Klammern versehen, um den fakultativen Charakter dieser Bezugszeichen nur für den Fall, dass das Bauteil 11 als Batterie 23 ausgebildet ist, zu betonen.

Fig. 4 zeigt sehr schematisch auf der linken Seite einen Hochfrequenzpuls 24, der über den Probenkopf 5 in das Bauteil 11 eingeleitet wird und dann als Antwort zu einem Spinresonanzsignal 25 führt, welches über den Probenkopf 5 aufgenommen wird. Statt einem Hochfrequenzpuls 24 können auch mehrere Hochfrequenzpulse 24 als eine Pulssequenz über den Probenkopf 5 in das Bauteil 11 eingeleitet werden. Es können also mit dem vorliegenden Verfahren nicht nur freie Induktionszerfälle, sondern auch Echosignale aufgenommen werden.

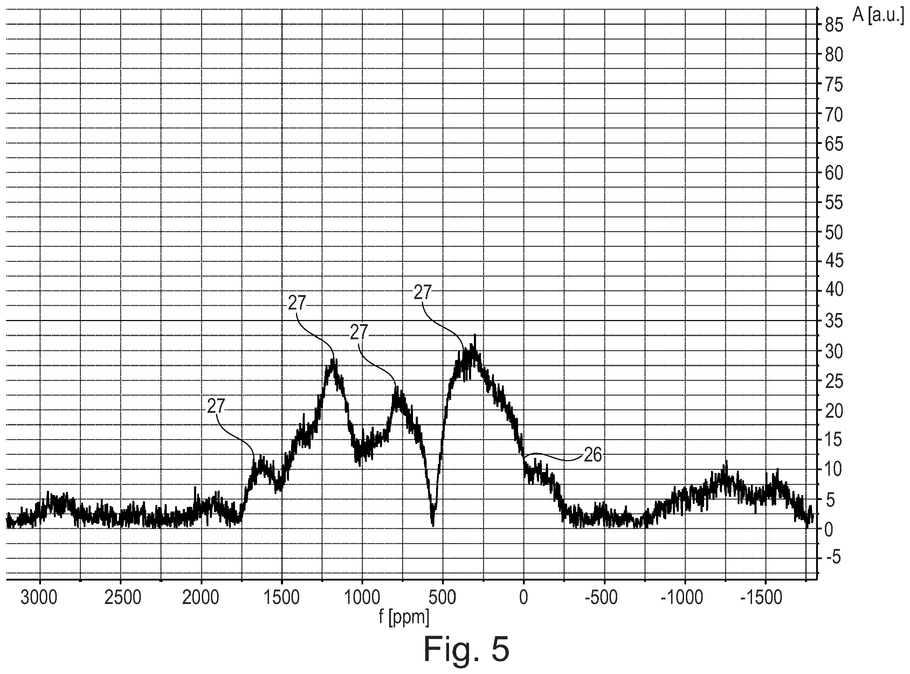

Fig. 5 zeigt schematisch ein mit dem hier beschriebenen Verfahren aufgenommenes Protonen (¹H)-Spektrum 26 einer kommerziell erhältlichen AA-Batterie. Das Spektrum wurde in einem zeitlich und räumlich homogenen Magnetfeld mit einer magnetischen Flussdichte von 1,144 T [Tesla] bei einer Resonanzfrequenz des Hochfrequenz-pulses von 48,409 MHz [Megahertz] gemessen. Das zeitlich und räumlich homogene Magnetfeld wurde dabei durch einen konventionellen Elektromagneten erzeugt. Das gezeigte Spektrum ist die Fouriertransformierte des gemessenen Spinresonanzsignals 25. Auf der Abszissenachse ist die entsprechende Frequenz f in ppm [parts per million] aufgetragen, während auf der Ordinatenachse die Amplitude A in willkürlichen Einheiten [arbitrary units, a.u.] aufgetragen ist. Zu erkennen sind mehrere Peaks 27 verschiedener Breiten, die bei unterschiedlichen Frequenzen ausgebildet sind.

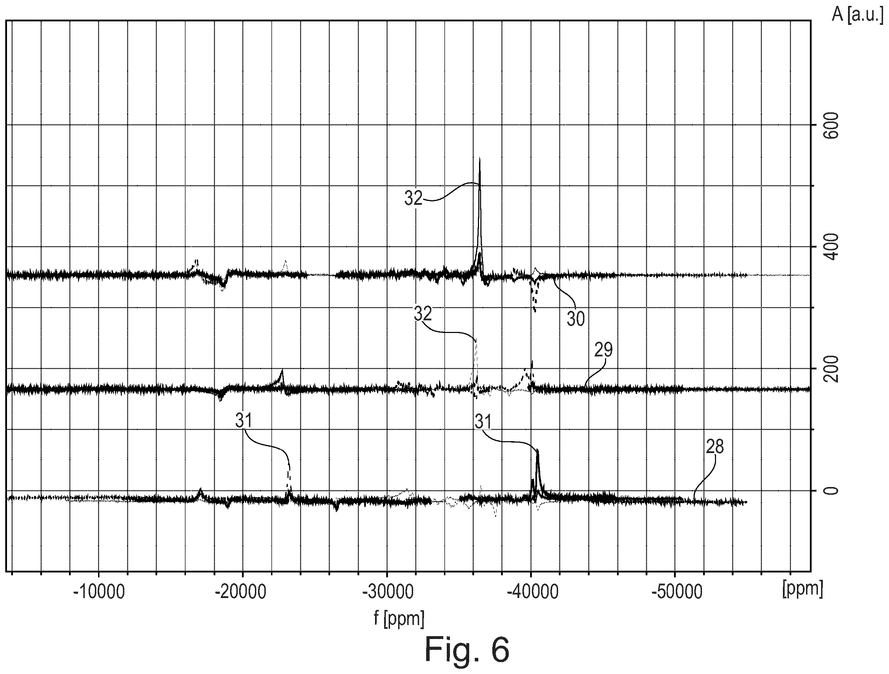

Fig. 6 zeigt drei mit dem hier beschriebenen Verfahren aufgenommene Protonen (¹H)-Spektren 28, 29, 30 einer kommerziell erhältlichen AA-Batterie, die unter dem Markennamen "Energizer" vertrieben wird. Das erste Spektrum 28, welches unten abgebildet ist, wurde an der neuen, vollständig geladenen, Batterie aufgenommen. Das zweite Spektrum 29, welches in der Mitte gezeigt ist, wurde an derselben allerdings entladenen Batterie aufgenommen, während das dritte Spektrum 30, welches oben gezeigt ist, ebenfalls an derselben entladenen Batterie aufgenommen worden ist, nachdem die Batterie aus dem Probenkopf 5 entnommen und wieder in diesen eingesetzt wurde. Die Spektren 28, 29, 30 wurden mit einem identischen zeitlich und räumlich konstanten Magnetfeld von 1,207 T aufgenommen bei einer Pulslänge des Hochfrequenz-Pulses von 16 Mikrosekunden und 5,67 W Leistung des Hochfrequenzpulses.

Das erste Spektrum 28 der vollständig geladenen Batterie zeigt zwei erste Hauptpeaks 31, während das zweite Spektrum 29 und das dritte Spektrum 30 jeweils einen zweiten Hauptpeak 32 zeigen. Die Frequenz des zweiten Hauptpeaks 32 ist im zweiten Spektrum 29 und im dritten Spektrum 30 im Rahmen der Messgenauigkeit identisch. Die Frequenz des zweiten Hauptpeaks 32 unterscheidet sich deutlich von den Frequenzen der ersten Hauptpeaks 31 im ersten Spektrum 28. Somit kann anhand des hier vorgestellten Verfahrens der Ladezustand einer Batterie bestimmt werden.

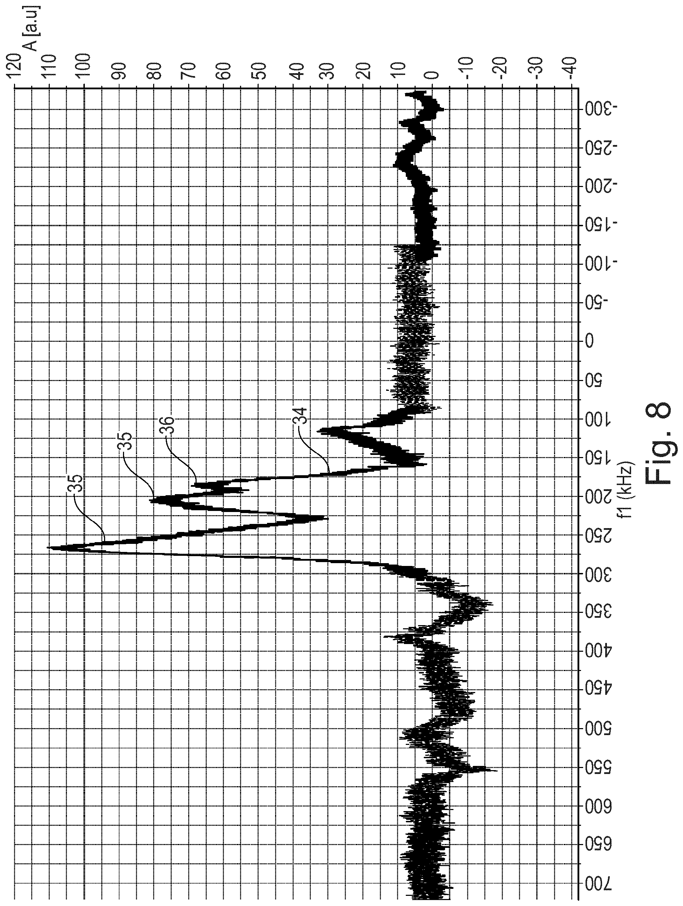

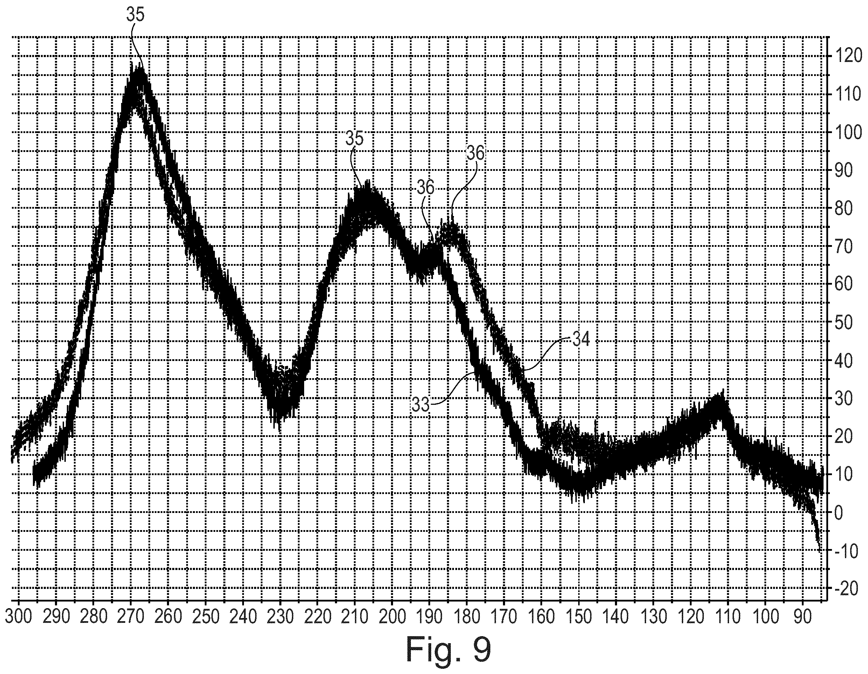

Fig. 7 bis 9 zeigen 7-Lithium (⁷Li)-Spektren einer kommerziell unter dem Markennamen Varta vertriebenen AAA-Batterie. Fig. 7 zeigt ein erstes ⁷Li-Spektrum der Batterie im aufgeladenen Zustand, während Fig. 8 ein entsprechendes zweites Spektrum der Batterie im entladenen Zustand zeigt. Fig. 9 zeigt einen Ausschnitt des ersten Spektrums 33 überlagert mit dem entsprechenden Ausschnitt des zweiten Spektrums 34. Das erste Spektrum 33 weist zwei Hauptpeaks 35 und einen Nebenpeak 36 auf. Diese sind auch im zweiten Spektrum 34 zu erkennen, wobei sich die Frequenz des Nebenpeaks 36 im Vergleich zum an der voll aufgeladenen Batterie aufgenommenen ersten Spektrum 33 (vgl. insb. Fig. 9) deutlich verschiebt. So lässt sich auch mit 7Li-NMR Messungen nach dem hier vorgestellten Verfahren der Ladezustand einer Batterie messen. Die den Spektren 33, 34 zugrunde liegenden Messungen wurden bei identischen Versuchsbedingungen durchgeführt (B0-Feld von 1,224 T, Frequenz des Hochfrequenz-pulses 20,260 MHz, Pulslänge 2 Mikrosekunden bei 20 Watt Leistung.

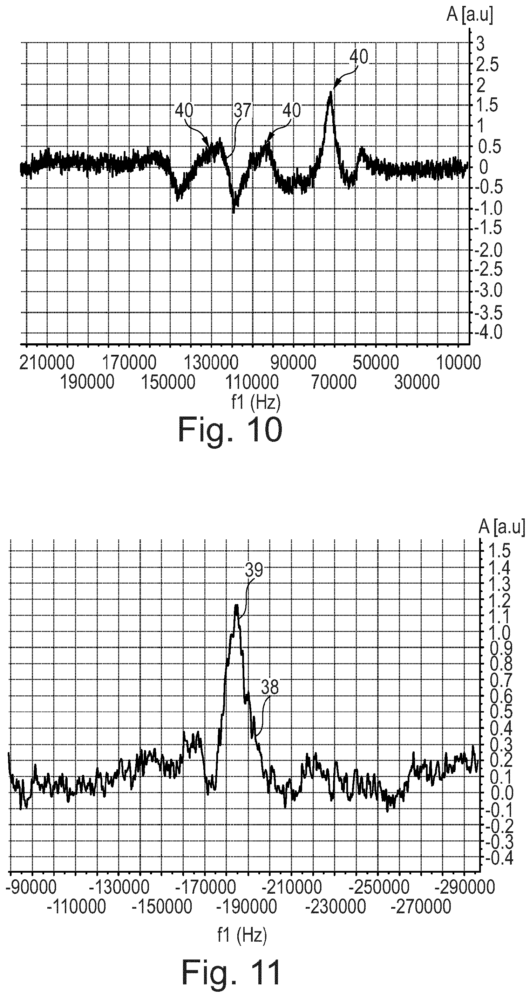

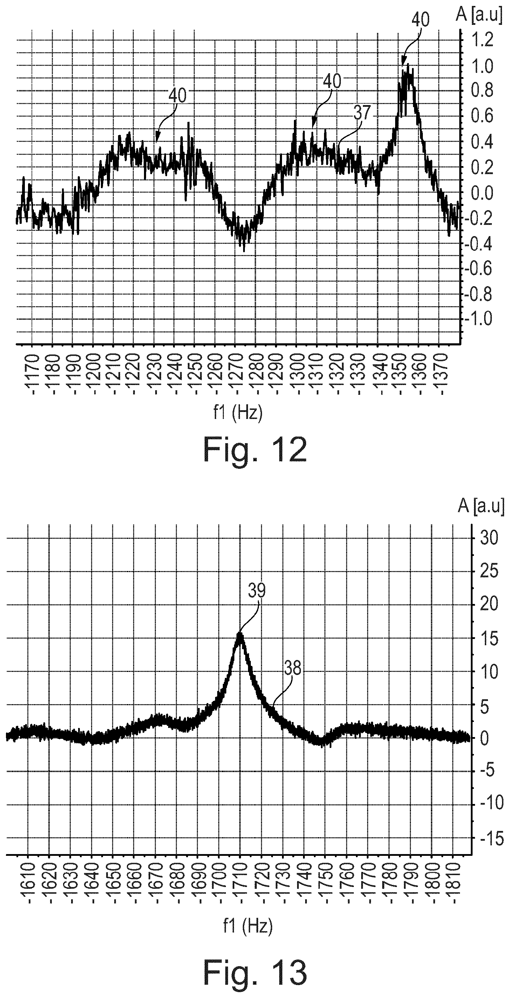

Während die in den bisherigen Figuren betrachteten AA- und AAA-Batterien längliche Zylinder darstellen, also eine Stirnfläche des Zylinders kleiner ist als die Mantelfläche des Zylinders, zeigen die Figuren 10 bis 13 ⁷Li-NMR-Spektren, die an flachen Batterien aufgenommen wurden oder allgemeiner an Batterien mit einem flächigen Aufbau mit zwei einander gegenüberliegenden größten Flächen, die jeweils größer ist als die anderen Flächen. Fig. 10 und 11 zeigen ⁷Li-Spektren, die an einer geladenen Knopfzelle, die unter dem Markennamen Conrad LIR2450 im Handel ist, aufgenommen wurden, während die Fig. 12 und 13 ⁷Li-Spektren zeigen, die an einem geladenen quaderförmigen Akku für Kameras der Marke Canon durchgeführt wurden. Die in Fig. 10 und 11 aufgenommenen Spektren wurden bei einem BO-Feld von etwa 1,031 T (entspricht einer Larmorfrequenz von ⁷Li von etwa 17,06 MHz) aufgenommen, während die Spektren in Fig. 12 und 13 bei einem BO-Feld von 1,070 T (entspricht einer Larmor-Frequenz von etwa 17,706 MHz) aufgenommen wurden.

Fig. 10 und 12 zeigen dabei erste Spektren 37, die in einem Aufbau aufgenommen wurden, bei dem die größte Fläche der Batterie senkrecht zum BO-Feld ausgerichtet war, während die Fig. 11 und 13 zweite Spektren 38 zeigen, die bei einem Aufbau aufgenommen wurden, bei denen die größte Fläche parallel zum BO-Feld ausgerichtet war. Die zweiten Spektren 38 in Fig. 11 und 13 zeichnen sich durch jeweils einen einzigen Hauptpeak 39 aus, während die ersten Spektren 37 mehrere Peaks 40 zeigen. Die Ausrichtung von flächigen Bauteilen so, dass die größte Fläche parallel zum B0-Feld ausgerichtet ist, ist bevorzugt, da hierdurch ein eindeutiges Spektrum erhalten werden kann. Auch dieses Spektrum ist abhängig vom Ladezustand der Batterie.

Das hier beschriebene Verfahren erlaubt die Durchführung von NMR-Messungen an elektrischen Bauteilen wie Batterien oder Kondensatoren. Hierbei wird das Bauteil direkt Teil eines Schwingkreises 7 eines NMR-Probenkopfes 5, in dem die Pole 13, 14 mit den anderen Elementen des Schwingkreises 7 elektrisch verbunden und dann der Probenkopf 5 in ein zeitlich und räumlich konstantes Magnetfeld 3 eingebracht wird. Es werden Puls-NMR Messungen durchgeführt, bei denen durch mindestens einen Hochfrequenzpuls 24 ein Spinresonanzsignal 25 erzeugt und aufgezeichnet wird. Das aus diesem Spinresonanzsignal 25 gebildete Spektrum 26, 28,29,30, 33, 34, 37, 38 ist abhängig vom Zustand des Bauteils 11, insbesondere vom Ladezustand einer Batterie oder vom allgemeinen Zustand der Batterie oder des Kondensators.

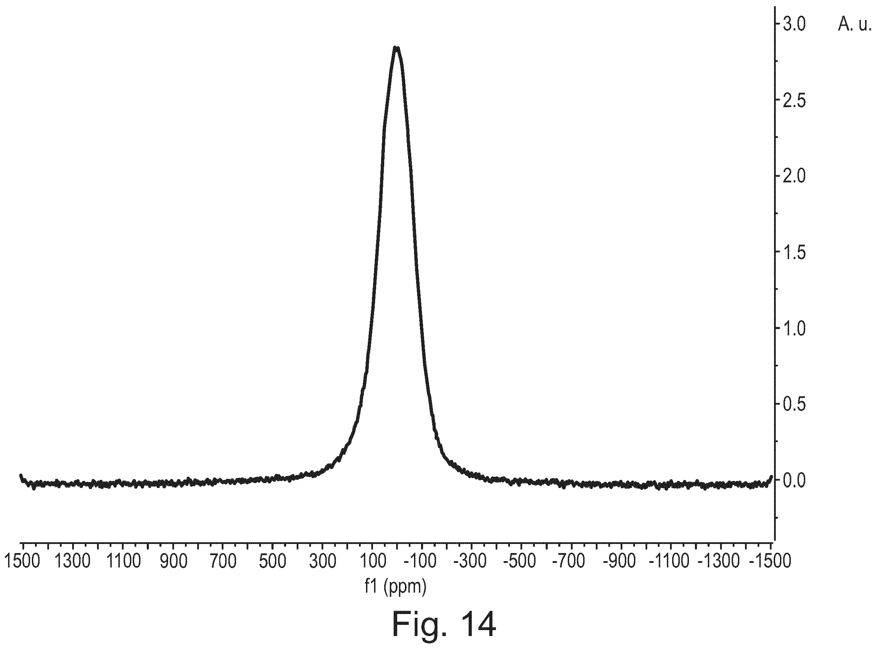

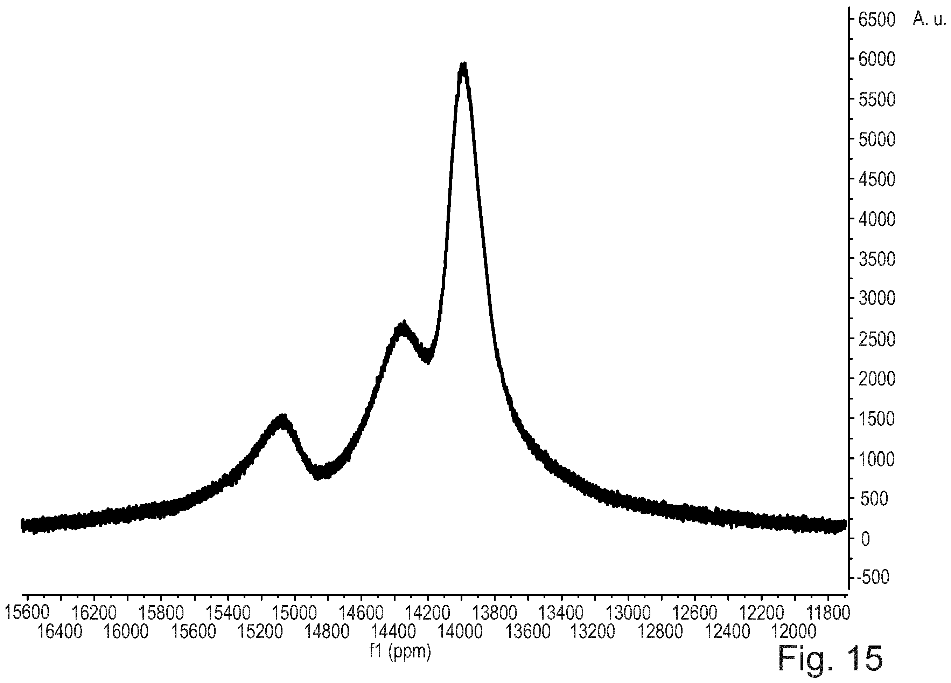

Fig. 14 zeigt ein ⁷Li-Spektrum und Fig. 15 ein ⁵⁹Co-Spektrum eines Wickels einer Batterie vom Typ 18650 LCO. Der verwendete Wickel war für den Zusammenbau einer Batterie vom Typ 18650 präpariert. Der Wickel wurde als Resonator verwendet. Der Wickel war auf einer Elektrode mit Kohlenstoff und auf der anderen Elektrode mit Lithiumcobaltoxid als Aktivmaterial beschichtet.

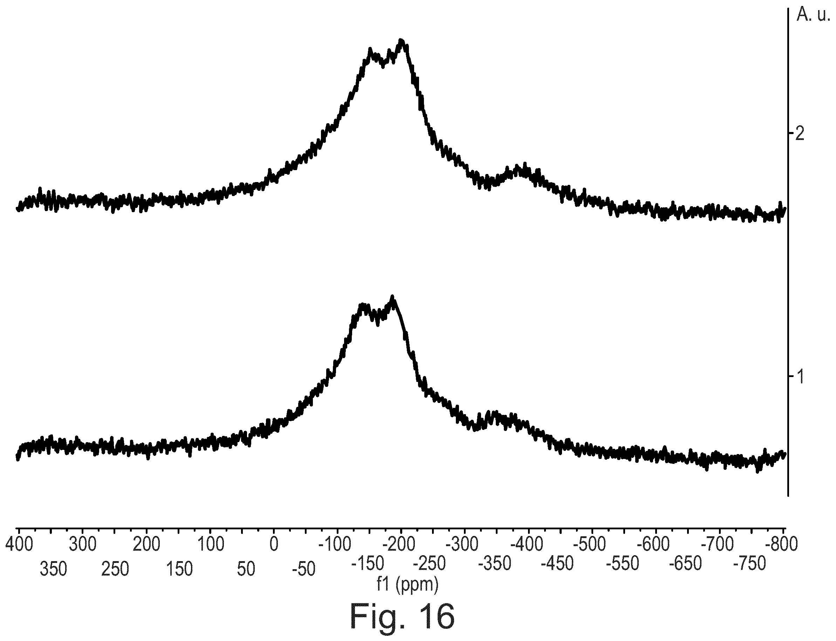

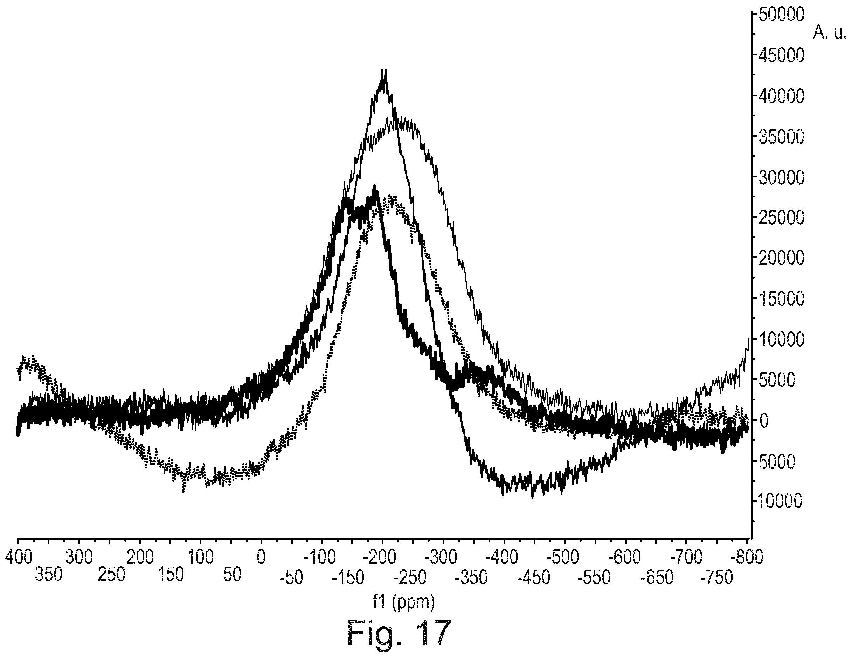

Fig. 16 und 17 zeigen ⁷Li-Spektren verschiedener Batterien vom Typ 18650. In Fig. 16 sind die Spektren von zwei kommerziell erhältlichen Batterien mit der Bezeichnung Samsung 35E Li gezeigt. Es zeigt sich an diesem Beispiel, dass die Spektren verschiedener Batterien der gleichen Serie eines Herstellers einander ähnlich sind. Auch kann selbst bei kommerziell verfügbaren Batterien vom Typ 18650 eine chemische Information erhalten werden.

Die in Fig. 16 gezeigten Spektren wurden mittels NMR bei 400 MHz aufgenommen. In Fig. 17 sind die Spektren von vier kommerziell erhältlichen Batterien unterschiedlicher Hersteller gezeigt: Samsung 35E Li, Panasonic NCR 18650D, LG INR 18650-M29 und Samsung ICR 30B. Es zeigt sich an diesem Beispiel, dass die Spektren von Batterien unterschiedlicher Hersteller unterschiedlich sind.

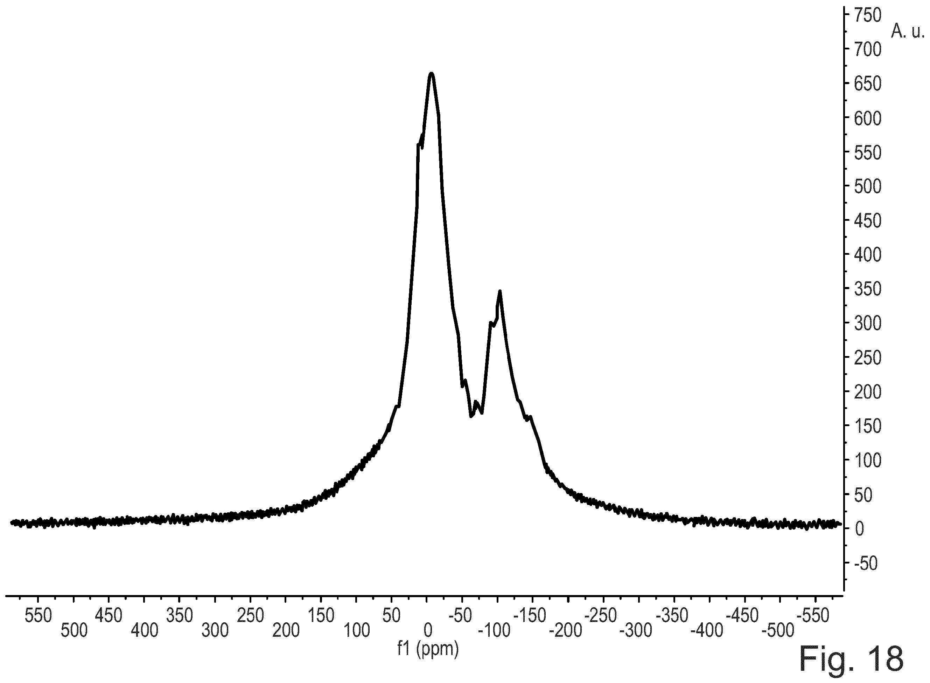

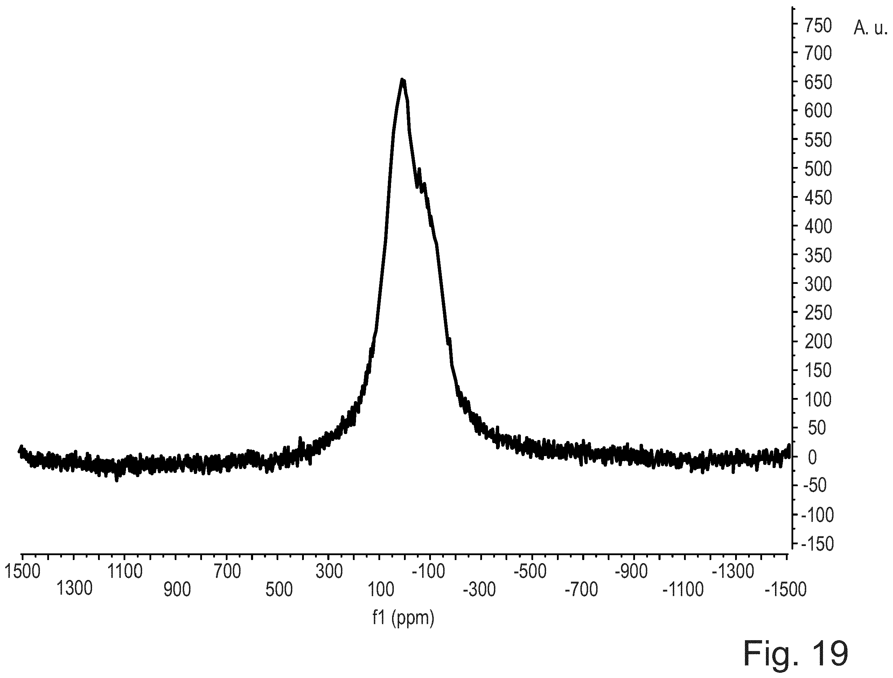

Fig. 18 zeigt ein ¹H-Spektrum einer Pouchbag-Zelle vom Typ "LCO vs. Carbon". Fig. 19 zeigt ein ⁷Li -Spektrum dieser Pouchbag-Zelle.

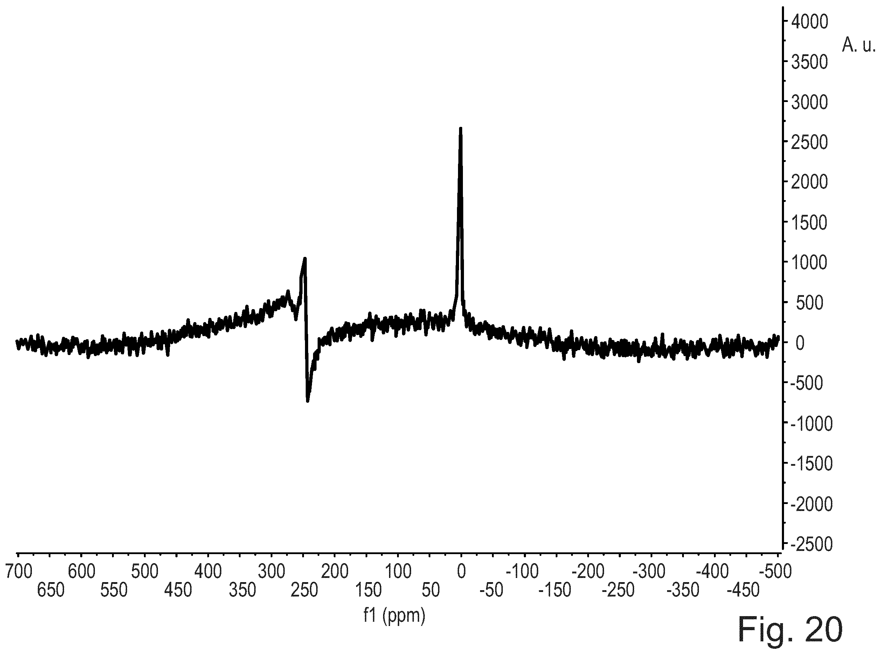

Fig. 20 zeigt ein ⁷Li-Spektrum einer Swagelok-Zelle mit Lithium-Metall und Lithium-Nickel-Cobalt-Aluminiumoxid (LNCA). Diese wird auch als "LNCA vs. Li in operando" bezeichnet.

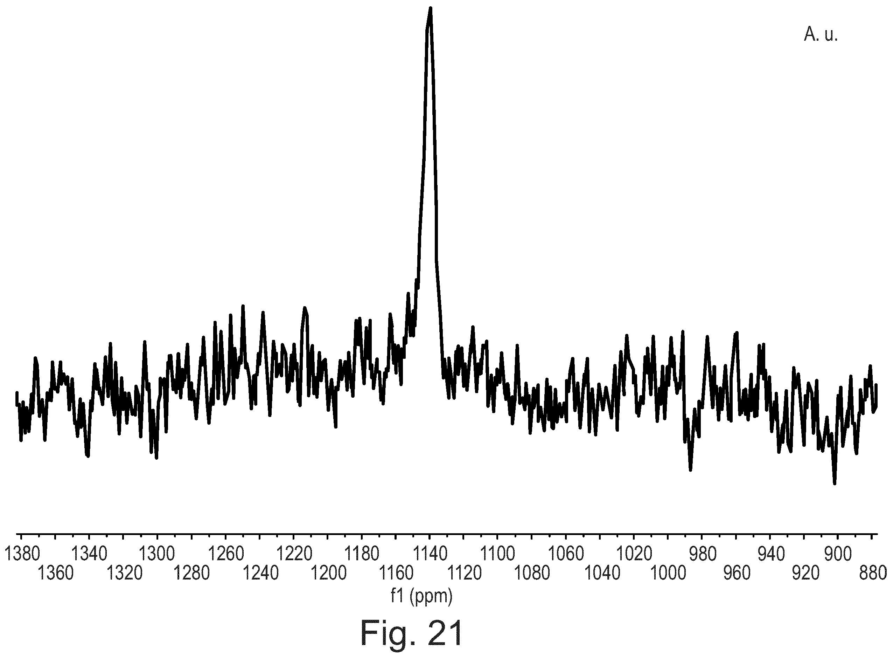

Fig. 21 zeigt ein ²³Na-Spektrum einer Swagelok-Zelle mit Natrium-Metall und Hardcarbon. Diese wird auch als "Carbon vs. Na" bezeichnet.

### Bezugszeichen

- 1: Vorrichtung zum Charakterisieren einer Batterie
- 2: Magnet
- 3: zeitlich und räumlich konstantes Magnetfeld
- 4: Probenaufnahmeraum
- 5: Probenkopf
- 6: NMR Spektrometer
- 7: Schwingkreis
- 8: Kondensator
- 9: erster abstimmbarer Kondensator
- 10: zweiter abstimmbarer Kondensator
- 11: Bauteil
- 12: Bauteilaufnahme
- 13: erster Pol
- 14: zweiter Pol
- 15: erste Elektrode
- 16: zweite Elektrode
- 17: Substanz
- 18: Separator
- 19: anodischer Teil
- 20: Anode
- 21: kathodischer Teil
- 22: Kathode
- 23: Batterie
- 24: Hochfrequenzpuls
- 25: Spinresonanzsignal
- 26: Spektrum
- 27: Peak
- 28: erstes Spektrum
- 29: zweites Spektrum
- 30: drittes Spektrum
- 31: erster Hauptpeak
- 32: zweiter Hauptpeak
- 33: erstes Spektrum
- 34: zweites Spektrum
- 35: Hauptpeak
- 36: Nebenpeak
- 37: erstes Spektrum
- 38: zweites Spektrum
- 39: Hauptpeak
- 40: Peak

## Patentansprüche

1. Verfahren zum Untersuchen eines elektrischen Bauteils (11) mit einem ersten Pol (13) und einem zweiten Pol (14),
wobei das Bauteil (11) über die Pole (13, 14) elektrisch verbindbar ist, wobei das Bauteil (11) zwei Elektroden (15, 16, 20, 22) aufweist, wobei jeweils eine Elektrode (15, 16, 20, 22) mit genau einem Pol (13, 14) elektrisch verbunden ist und das Bauteil (11) keine metallische Verbindung zwischen den Elektroden (15, 16, 20, 22) aufweist, wobei in dem Bauteil (11) zwischen den Elektroden (13, 14) eine Substanz (17) ausgebildet ist,
wobei das Bauteil (11) einem zeitlich konstanten Magnetfeld (3) und einem impulsförmig geschalteten Hochfrequenzfeld (24) ausgesetzt wird und die Daten in Form mindestens eines Spinresonanzsignals (25) gemessen werden, **dadurch gekennzeichnet, dass**
das Bauteil (11) über seine Pole elektrisch (13, 14) in einen Schwingkreis (7) eingebunden wird, über den das Hochfrequenzfeld (24) innerhalb des Bauteils (11) angeregt und das Spinresonanzsignal (25) aufgenommen wird.

2. Verfahren nach Anspruch 1, bei dem der Schwingkreis (7) mindestens zwei abstimmbare Kondensatoren (9, 10) umfasst, über die die Frequenz und Impedanz des Schwingkreises (7) anpassbar ist.

3. Verfahren nach einem der vorhergehenden Ansprüche, bei dem die Substanz (7) einen Elektrolyten umfasst.

4. Verfahren nach einem der vorhergehenden Ansprüche, bei dem die Substanz (7) ein Dielektrikum umfasst.

5. Verfahren nach einem der vorhergehenden Ansprüche, bei dem das Bauteil (11) einen Kondensator umfasst.

6. Verfahren nach einem der Ansprüche 1 bis 3, bei dem das Bauteil (11) eine Batterie oder einen Wickel für eine Batterie umfasst.

7. Verfahren nach einem der vorhergehenden Ansprüche, bei dem anhand der magnetischen Flussdichte des räumlich und zeitlich konstanten Magnetfeldes (3) die Resonanzfrequenz eines der folgenden Atomkerne bestimmt wird: 1-Wasserstoff (¹H); 6-Lithium (⁶Li); 7-Lithium (⁷Li); 13-Kohlenstoff (¹³C); 14-Stickstoff (14N); 19-Fluor (¹⁹F); 23-Natrium (²³Na); 27-Aluminium (²⁷Al); 29-Silicium (²⁹Si); 31-Phosphor (³¹P); 39-Kalium (³⁹K); 59-Cobalt (⁵⁹Co) oder 207-Blei (²⁰⁷Pb) und diese Resonanzfrequenz als Frequenz des Hochfrequenzfeldes eingesetzt wird.

8. Verfahren nach einem der vorhergehenden Ansprüche, bei dem das Bauteil (11) einen zylinderförmigen Aufbau mit einer Zylinderachse aufweist und die Zylinderachse in Richtung des magnetischen Flusses des zeitlich und räumlich homogenen Magnetfeldes ausgerichtet ist.

9. Verfahren nach einem der Ansprüche 1 bis 7, bei denen das Bauteil (11) einen flächigen Aufbau mit zwei gegenüberliegenden größten Fläche aufweist und das Bauteil so ausgerichtet ist, dass die größte Fläche in Richtung des magnetischen Flusses des zeitlich und räumlich homogenen Magnetfeldes ausgerichtet ist.

10. Verfahren nach einem der vorhergehenden Ansprüche, bei dem das zeitlich konstante Magnetfeld räumlich konstant ist.

11. Verfahren nach einem der Ansprüche 1 bis 9, bei dem das zeitlich konstante Magnetfeld mindestens in einer Raumrichtung einen Gradienten aufweist.

## Claims

1. Method for examining an electrical component (11) having a first pole (13) and a second pole (14),
wherein the component (11) is electrically connectable via the poles (13, 14), wherein the component (11) has two electrodes (15, 16, 20, 22), wherein one electrode (15, 16, 20, 22) is electrically connected in each case to precisely one pole (13, 14) and the component (11) does not have a metallic connection between the electrodes (15, 16, 20, 22), wherein a substance (17) is formed in the component (11) between the electrodes (13, 14),
wherein the component (11) is subjected to a temporally constant magnetic field (3) and a high-frequency field (24) switched in pulses and the data are measured in the form of at least one spin resonance signal (25),
**characterized in that**
the component (11) is electrically incorporated via its poles (13, 14) in a resonant circuit (7), via which the high-frequency field (24) is excited inside the component (11) and the spin resonance signal (25) is recorded.

2. Method according to Claim 1, in which the resonant circuit (7) comprises at least two tunable capacitors (9, 10), via which the frequency and impedance of the resonant circuit (7) is adaptable.

3. Method according to either of the preceding claims, in which the substance (7) comprises an electrolyte.

4. Method according to any of the preceding claims, in which the substance (7) comprises a dielectric material.

5. Method according to any of the preceding claims, in which the component (11) comprises a capacitor.

6. Method according to any of Claims 1 to 3, in which the component (11) comprises a battery or a winding for a battery.

7. Method according to any of the preceding claims, in which the resonance frequency of one of the following atomic nuclei is determined on the basis of the magnetic flux density of the spatially and temporally constant magnetic field (3): 1-hydrogen (¹H); 6-lithium (⁶Li); 7-lithium (⁷Li); 13-carbon (¹³C); 14-nitrogen (¹⁴N); 19-fluorine (¹⁹F); 23-sodium (²³Na); 27-aluminium (²⁷Al); 29-silicon (²⁹Si); 31-phosphorus (³¹P); 39-potassium (³⁹K); 59-cobalt (⁵⁹Co) or 207-lead (²⁰⁷Pb) and this resonance frequency is used as the frequency of the high-frequency field.

8. Method according to any of the preceding claims, in which the component (11) has a cylindrical structure having a cylinder axis, and the cylinder axis is aligned in the direction of the magnetic flux of the temporally and spatially homogeneous magnetic field.

9. Method according to any of Claims 1 to 7, in which the component (11) has a flat structure having two opposing largest surfaces and the component is aligned such that the largest surface is aligned in the direction of the magnetic flux of the temporally and spatially homogeneous magnetic field.

10. Method according to any of the preceding claims, in which the temporally constant magnetic field is spatially constant.

11. Method according to any of Claims 1 to 9, in which the temporally constant magnetic field has a gradient at least in one spatial direction.

## Revendications

1. Procédé d'examen d'un composant électrique (11) doté d'un premier pôle (13) et d'un second pôle (14),
le composant (11) pouvant être connecté électriquement par l'intermédiaire des pôles (13, 14), le composant (11) comportant deux électrodes (15, 16, 20, 22), une électrode (15, 16, 20, 22) comportant respectivement une connexion électrique avec exactement un pôle (13, 14) et le composant (11) ne comportant aucune connexion métallique entre les électrodes (15, 16, 20, 22), une substance (17) étant formée dans le composant (11) entre les électrodes (13, 14),
le composant (11) étant exposé à un champ magnétique (3) constant dans le temps et à un champ haute fréquence commuté sous forme d'impulsions (24) et les données étant mesurées sous la forme d'au moins un signal de résonance de spin (25),
**caractérisé en ce que**
le composant (11) est intégré électriquement , par l'intermédiaire de ses pôles (13, 14), dans un circuit résonant (7), par l'intermédiaire duquel le champ haute fréquence (24) est excité à l'intérieur du composant (11) et le signal de résonance de spin (25) est acquis.

2. Procédé selon la revendication 1, dans lequel le circuit résonant (7) comprend au moins deux condensateurs accordables (9, 10) au moyen desquels la fréquence et l'impédance du circuit résonant (7) peuvent être adaptées.

3. Procédé selon l'une des revendications précédentes, dans lequel la substance (7) comprend un électrolyte.

4. Procédé selon l'une des revendications précédentes, dans lequel la substance (7) comprend un diélectrique.

5. Procédé selon l'une des revendications précédentes, dans lequel le composant (11) comprend un condensateur.

6. Procédé selon l'une des revendications 1 à 3, dans lequel le composant (11) comprend une batterie ou un enroulement destiné à une batterie.

7. Procédé selon l'une des revendications précédentes, dans lequel, sur la base de la densité de flux magnétique du champ magnétique (3) constant dans l'espace et dans le temps, la fréquence de résonance de l'un des noyaux atomiques suivants est déterminée : hydrogène-1 (¹H) ; lithium-6 (⁶Li) ; lithium-7 (⁷Li); carbone-13 (¹³C) ; azote-14 (¹⁴N) ; fluor-19 (¹⁹F) ; sodium-23 (²³Na) ; aluminium-27 (²⁷Al) ; silicium-29 (²⁹Si) ; phosphore-31 (³¹P) ; potassium-39 (³⁹K); cobalt-59 (⁵⁹Co) ou plomb-207 (²⁰⁷Pb), et cette fréquence de résonance est utilisée comme fréquence du champ haute fréquence.

8. Procédé selon l'une des revendications précédentes, dans lequel le composant (11) présente une structure cylindrique avec un axe de cylindre et l'axe de cylindre est orienté dans la direction du flux magnétique du champ magnétique homogène dans le temps et dans l'espace.

9. Procédé selon l'une des revendications 1 à 7, dans lequel le composant (11) présente une structure plane comportant deux plus grandes surfaces opposées et le composant est orienté de telle sorte que la plus grande surface est orientée dans la direction du flux magnétique du champ magnétique homogène dans le temps et dans l'espace.

10. Procédé selon l'une des revendications précédentes, dans lequel le champ magnétique constant dans le temps est constant dans l'espace.

11. Procédé selon l'une des revendications 1 à 9, **caractérisé en ce que** le champ magnétique constant dans le temps présente un gradient au moins dans une direction spatiale.
